# EUROPÄISCHE PATENTANMELDUNG

(11) **EP 2 453 330 A1**
(43) Veröffentlichungstag der Anmeldung: **16.05.2012**
(21) Anmeldenummer: 10014593.7
(22) Anmeldetag: 13.11.2010
(51) Int. Cl.: G05B 23/02

(54) **Intelligente Visualisierung der Überwachung von Prozess- und/oder Anlagegrössen**

(71) Anmelder: ABB Technology AG, 8050 Zürich (CH)
(72) Erfinder: Chioua, Moncef, Dr., 69115 Heidelberg (DE); Hollender, Martin, Dr., 69221 Dossenheim (DE)
(74) Vertreter: Partner, Lothar

(57) **Zusammenfassung**

Die Erfindung betrifft ein Verfahren und ein System zur intelligenten Visualisierung bei der Überwachung von Prozess- und/oder Anlagedaten, welche bei technischen Verfahren beziehungsweise beim Betrieb technischer Anlagen benutzt werden. Das Verhalten der Signale in der Vergangenheit wird analysiert und für eine zukünftig optimierte Visualisierung genutzt. Kontinuierlich laufende Online-Algorithmen unterstützen die Anlagenfahrer, indem sie Abweichungen von den historisch beobachteten Signalmustern erkennen und entsprechend hervorheben.

## Beschreibung

Die Erfindung betrifft ein Verfahren und ein System zur intelligenten Visualisierung bei der Überwachung von Prozess- und/oder Anlagegrößen, insbesondere von sogenannten Massedaten, also einer Vielzahl von Prozess- und/oder Verfahrensdaten, welche während des Betriebes technischer Anlagen oder dem Ablauf technischer Prozesse auftreten. Die Erfindung ist zur grafischen Darstellung Prozessdaten, insbesondere von Massedaten, auf einer Anzeigevorrichtung, nachfolgend auch Display genannt, vorzugsweise einem Bildschirm, in der in der Anlagentechnik, Leittechnik und Verfahrensplanung geeignet.

Sogenannte Massendatendisplays können eine große Zahl normierter Prozessgrößen auf vergleichsweise wenig Bildschirmplatz darstellen. Bei großen technischen Anlagen, beispielsweise einem Kraftwerk, ist es häufig nicht einfach möglich zu spezifizieren, welche der oftmals vielen tausend Prozess- und Anlagegrößen für eine Visualisierung wichtig sind. Deshalb sollte die Konfiguration und Kalibrierung von Massendatendisplays durch automatisierte Verfahren möglichst gut unterstützt werden, um die Vorteile einer übersichtlichen und aussagekräftigen Darstellung möglichst gut nutzen zu können. Menschliches Wahrnehmungsvermögen von jedwelchen Zeichen oder Mustern reagiert besonders sensibel auf deren Veränderungen und Abweichungen sowie auf Unregelmäßigkeiten.

Diese Tatsache wird benutzt bei entsprechenden Anzeigen wie der Anzeige von sogenannten Massedaten, also einer Vielzahl von Daten auf einem Display. Dabei ist es von Bedeutung, dass während des ungestörten Normalbetriebes einer technischen Anlage oder eines technischen Prozesses die Anzeige der Verfahrensparameter sowie der Zustände der Anlagenkomponenten, zu denen auch die Messstellen innerhalb der technischen Anlage zählen, so regelmäßig wie möglich erfolgt und sich so wenig wie möglich für das menschliche Wahrnehmungsvermögen verändert.

Dennoch kann angesichts der Begleitumstände des Verfahrens beziehungsweise der Zustände der Anlagenkomponenten und Messstellen infolge von Rauschen ein gewisser Grad an Unruhe und Unregelmäßigkeiten auch während des Normalbetriebs der Anlage bzw. dem Ablauf des Verfahrens ohne irgendwelche Störungen oder äußere Einflussfaktoren nicht vermieden werden.

Je größer die Unregelmäßigkeit und Unruhe infolge des Rauschens ist, desto weniger brauchbar ist die Anzeige, beispielsweise auf einem Display eines Bildschirms der übergeordneten Steuerungsebene eines Automatisierungssystems.

Obgleich von der Anzeige sogenannter Massedaten auf einem Display viele Vorteile resultieren wegen des hohen Grades an Abstraktion, tendieren heute viele Anlagenfahrer großer technischer Anlagen, wie beispielsweise in einem Kraftwerk zur Wiedergabe von realen Prozess- und/oder Anlagekennwerten auf dem Display der Leitwarte.

Oftmals enthalten diese Anzeigen über die Prozess- und Anlagenzustände nur relativ wenige Prozess- und/oder Anlagengrößen. Typischerweise werden auf den Anlagenübersichtbildern maximal einige hundert der wichtigsten Werte angezeigt. Der Kostenaufwand für deren Überwachung steigt deutlich mit der Anzahl der zur Verfügung stehenden Prozess- und/oder Anlagedaten an. Limitierend ist dabei vor allem die Aufnahmefähigkeit der Anlagenfahrer und der zur Verfügung stehende Bildschirmplatz, da Menschen nur eine begrenzte Anzahl von Werten parallel überwachen können. Wertet man Störfälle retrospektiv aus, stellt sich oftmals heraus, dass für eine frühzeitige Erkennung der sich anbahnenden Störung eine bestimmte Prozessgröße hätte angezeigt werden müssen, der bislang als relativ unwichtig galt. Massendatendisplays bieten die Möglichkeit eine große Anzahl von Werten systematisch anzuzeigen.

Im Falle, dass eine der Prozess- und/oder Anlagengröße periodischen Schwingungen unterliegt, bedeutet dies entsprechende Unschärfen in ihrer Darstellung, wobei Schwingungen häufig nicht als solche durch den Anlagenfahrer der Anlage erkannt werden und daher oft als Versatz interpretiert werden. Schnelle Schwingungen der Anlagen-/ oder Prozessgrößen führen zu Unruhe im Massendatendisplay.

Ausgehend von diesen im Stand der Technik beobachteten Nachteilen ist es Aufgabe der Erfindung, ein Verfahren zur intelligenten Visualisierung bei der Überwachung von Prozess- und/oder Anlagegrößen, insbesondere von sogenannten Massedaten, anzugeben, welches die vorstehend genannten Nachteile vermeidet und darüber hinaus insbesondere den Aufwand für eine Kalibrierung auf einen vernünftigen und für den Bediener der Anlage überschaubaren Rahmen beschränkt, wobei während des Normalbetriebes Unruhe und Unregelmäßigkeiten in der Anzeige der Massedaten deutlich unterhalb des Grenzwertes liegen, bei welchem eine Anzeige der die Anzeige Prozess- und/oder Anlagegrößen unbrauchbar wird.

Dazu wird das Verhalten der Signale in der Vergangenheit analysiert und für eine zukünftig optimierte Visualisierung genutzt. Kontinuierlich laufende Online-Algorithmen unterstützen dabei die Anlagenfahrer, indem sie Abweichungen von historisch beobachteten Signalmustern erkennen und entsprechend hervorheben.

Ferner sollte ein schnelles Umschalten von einer normierten abstrakten Darstellung auf eine herkömmliche Wiedergabe der Prozess- und/oder Anlagegrößen bzw. Prozess- und/oder Anlagedaten, wie eine Trendanzeige vorgesehen sein.

Diese Aufgabe wird erfindungsgemäß durch ein Verfahren der eingangs genannten Art mit den im Anspruch 1 angegebenen Merkmalen gelöst. Vorteilhafte Ausgestaltungen, Verbesserungen des erfindungsgemäßen Verfahrens sowie ein System zur Ausführung des Verfahrens sind in weiteren Ansprüchen und in der Beschreibung angegeben.

Demgemäß ist erfindungsgemäß vorgesehen, dass zur intelligenten Visualisierung bei der Überwachung von Prozess- und/oder Anlagedaten, insbesondere von sogenannten Massedaten, die beispielsweise Messwerte, Prozessgrößen und/oder Zustandsmeldungen einer technischen Anlage oder eines technischen Prozesses umfassen, die Erkenntnis ausgenutzt wird, dass sich viele Prozess- und/oder Anlagedaten aus verschiedenen Gründen nicht ändern, und hierbei die Annahme gilt, dass Prozess- und/oder Anlagedaten sich in der Zukunft nicht ändern werden, wenn sie sich zumindest für einen gewissen Zeitraum in der Vergangenheit nicht geändert haben, wobei eine große Anzahl von diesen sogenannten stillen Signalen in einer einzigen Ansicht bzw. Darstellungsform, vorzugsweise dem Display eines Bildschirms zusammengefasst werden. Ein Beispiel hierfür ist der Öffnungsgrad eines Sicherheitsventils, das normalerweise geschlossen ist. Für den Normalbetrieb der Anlage spielt dieser - immer gleiche - Öffnungsgrad keine Rolle, öffnet das Ventil aber aufgrund außergewöhnlicher Umstände doch, so ist dies eine wichtige Information, die dem Anlagenfahrer explizit dargestellt werden sollte.

Erfindungsgemäß werden die stillen Signale, im vorab genannten Beispiel das geschlossene Ventil, mittels geeigneter Algorithmen überwacht und im Falle, dass ein Signal aktiv wird, also das Ventil geöffnet wird, dieses im Display hervorgehoben, angezeigt und/oder gemeldet wird.

In einer Ausgestaltung der Erfindung wird nur dann ein Signal als "aktiv" angesehen bzw. gesetzt, wenn eine geschätzte Varianz einer Prozess- und/oder Anlagengrößeeinen vorkonfigurierten Schwellwert überschreitet.

In einer weiteren Ausgestaltung des erfindungsgemäßen Verfahrens wird eine Ähnlichkeits-Metrik definiert und ein Algorithmus, wie beispielsweise eine Korrelation oder Principal Component Analysis (PCA) zur Auswertung der Ähnlichkeits-Metrik für alle Prozess- und/oder Anlagedaten angewendet.

Vorzugsweise werden alle Prozess- und/oder Anlagedaten, die als ausreichend ähnlich ermittelt worden sind, in einem einzigen Display bzw. in einer einzigen Ansicht angezeigt, wobei vorgesehen sein kann, dass die Ähnlichkeits-Metrik kontinuierlich regelmäßig mittels eines Auswertemoduls ausgewertet wird und Signale, die nicht mehr den Ähnlichkeits-Kriterien gehorchen, automatisch mittels eines Filtermoduls herausgefiltert und in einer separaten Darstellung bereitgestellt und/oder angezeigt werden.

Weiterhin werden in einer vorteilhaften Ausgestaltung des erfindungsgemäßen Verfahrens die Prozess- und/oder Anlagedaten online bezüglich dominanter Schwingungen mittels eines Analysemoduls analysiert, so dass beispielsweise detektierte dominante Schwingungen vom Signal entfernt und separat ausgewiesen werden.

Wie eingangs bereits angesprochen, betrifft die Erfindung auch eine Vorrichtung beziehungsweise ein System zur intelligenten Visualisierung bei der Überwachung von Prozess- und/oder Anlagedaten, insbesondere von Massedaten, welche bei technischen Verfahren beziehungsweise beim Betrieb technischer Anlagen üblich sind.

Erfindungsgemäß benutzt dieses Anzeigesystem beziehungsweise diese Anzeigevorrichtung zur intelligenten Visualisierung bei der Überwachung der Prozess- und/oder Anlagedaten eine einzigen Ansicht bzw. Darstellungsform zur Darstellung einer Vielzahl von stillen oder normierten Signalen mittels einer Hervorhebung, Meldung und/oder Anzeige.

Dabei erweist es sich als vorteilhaft, dass eine Überwachung der Signale mittels eines im System integrierten Überwachungsmoduls vorgesehen ist, wobei im Falle eines aktiven Signals dieses Signal vom Überwachungsmodul detektierbar ist und zu einer Ansicht des Displays übertragbar und/oder dort darstellbar ist.

In einer Ausgestaltung des erfindungsgemäßen Systems ist ein Schwellwertüberwachungsmodul vorgesehen, ein aktives Signal auswählt, wenn eine geschätzte Varianz der betreffenden Prozess- und/oder Anlagendaten einen vorkonfigurierten Schwellwert überschreitet.

Gemäß einer vorteilhaften Ausgestaltung der Erfindung ist das System dadurch gekennzeichnet, dass die Erstellung einer Ähnlichkeits-Metrik und deren Auswertung für alle Prozess- und/oder Anlagengrößen mittels eines vorgegebenen Algorithmus ausführbar ist und/oder alle Signale, die nicht mehr den Ähnlichkeits-Kriterien gehorchen, automatisch in einer Summendarstellung zur Anzeige bzw. zur Meldung kommen.

Entsprechend dem Verfahren ist auch beim erfindungsgemäßen System vorgesehen, alle Massedaten, die als ausreichend ähnlich ermittelt worden sind, in einem einzigen Display zur Anzeige kommen.

Erfindungsgemäß werden während der vorausgehenden Offline- Engineering- Phase vorhandene historische Prozessdaten, beispielsweise aus einem Plant Information Management System (PIMS) ausgewertet.

Sind - wie beispielsweise bei einer neu errichteten Anlage - bisher nur wenige historische Prozessdaten verfügbar, so können die beschriebenen Anzeigen zunächst nicht mit höchster Qualität funktionieren. Sobald zu einem späteren Zeitpunkt genügend historische Prozessdaten verfügbar sind, wird eine Kalibrierung der Anzeigen erneut durchgeführt.

Die gefundenen Charakteristika werden dann verwendet, um die Ansicht oder Darstellungsform zur Anzeige der Massedaten zu optimieren. Hierbei kann nach verschiedenen Kriterien vorgegangen werden, die in den nachfolgenden Figuren dargestellt sowie näher erläutert werden.

Es zeigen:
- **Fig. 1**: eine beispielhafte Summendarstellung stiller Signale,
- **Fig. 2**: eine beispielhafte Summendarstellung ähnlicher Signale,
- **Fig. 3**: eine beispielhafte detaillierte Schwingungsanzeige, und
- **Fig. 4**: eine beispielhafte Darstellung von Massedaten auf einem Display eines Bildschirms der übergeordneten Steuerungsebene eines Automatisierungssystems.

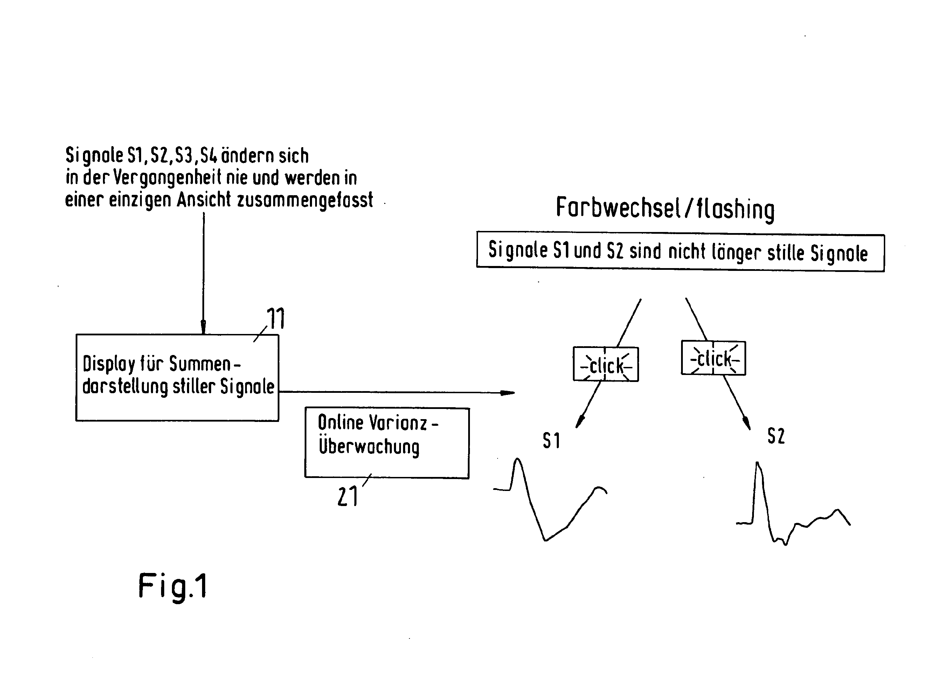

**Fig. 1** zeigt beispielhaft eine Summendarstellung stiller Signale S1, S2, S3, S4. Ausgangspunkt ist dabei die Betrachtung einer Gesamtmenge von gemessenen Prozess- und/oder Anlagengrößen, wobei sich viele Prozess- und/oder Anlagengrößen aus verschiedenen Gründen nicht ändern. Diese Größen können Komponenten betreffen, die im Normalbetrieb der Anlage immer gleich arbeiten, wie beispielsweise Überdruckventile, für die Konfigurationen von Massendatendisplays relevant sind aber auch Messungen mit defekten Sensoren. Es gilt hierbei die Annahme, dass, wenn sich die jeweiligen Prozess- und/oder Anlagengrößen, nachfolgend auch als Signale S1, S2, S3, S4 bezeichnet, nicht für einen gewissen, vorab definierten Zeitraum in der Vergangenheit geändert haben, es wahrscheinlich ist, dass sie sich auch in der Zukunft nicht ändern werden. Ändert sich ein solches Signal aber doch, so ist diese Tatsache vielfach von besonderer Bedeutung für die Anlagenfahrer.

Eine große Anzahl von stillen Signalen S1, S2, S3, S4 können somit in einer einzigen Ansicht (Display) bzw. Darstellungsform 11 zusammengefasst werden.

Die stillen Signale S1, S2, S3, S4 werden erfindungsgemäß mittels eines Überwachungsmoduls 21, welches eine Varianzüberwachung durchführt, überwacht und wenn ein Signal S1, S2 aktiv wird, beispielsweise weil die geschätzte Varianz einen vorkonfigurierten Schwellwert überschreitet, dann wird diese Tatsache, beispielsweise mittels eines Farbwechsels des angezeigten Signals im Display angezeigt. Das Überwachungsmodul zur Varianzüberwachung 21 wird dann kontinuierlich zur Online- Überwachung.

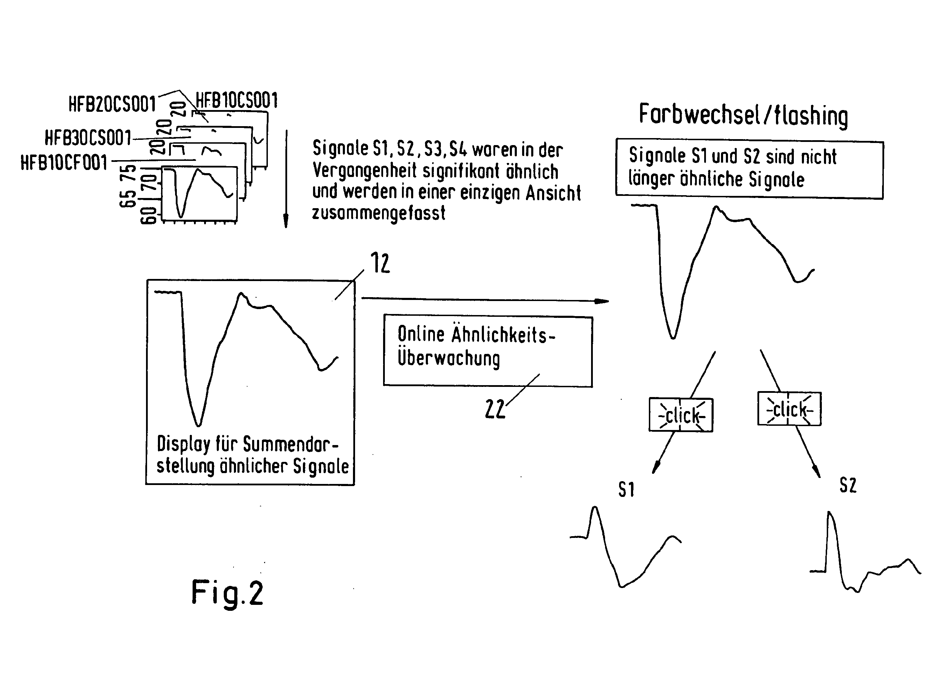

In **Fig. 2** ist beispielhaft eine Summendarstellung ähnlicher Signale S1, S2, S3, S4 gezeigt. Viele Prozess- und/oder Anlagengrößen verhalten sich ähnlich, zum Beispiel beim Vorhandensein von redundanten Messstellen. Solange sich die Messwerte der redundanten Messstellen gleich verhalten, also keine Abweichungen voneinander zeigen, besteht wenig Anlass, um alle Messwerte zu zeigen. Somit wird einem ersten Schritt eine Ähnlichkeits-Metrik definiert und ein angemessener Algorithmus, wie beispielsweise Korrelation oder Principal Component Analysis (PCA), zur Auswertung dieser Metrik auf alle relevanten Prozess- und/oder Anlagengrößen angewendet.

Alle Prozess- und/oder Anlagengrößen bzw. Prozess- und/oder Anlagesignale S1, S2, S3, S4, die dabei als ausreichend ähnlich ermittelt worden, werden dann in einem einzigen Display 12 angezeigt. Diese Ähnlichkeits-Metrik wird regelmäßig mittels eines vorgesehenen Auswertemoduls 22 ausgewertet und Signale S1, S2, die nicht mehr den Ähnlichkeits-Kriterien entsprechen, werden automatisch, beispielsweise mittels eines Farbumschlages, angezeigt. Das Auswertemodul 22 arbeitet dabei, wie vorab für das Überwachungsmodul 21 beschrieben, als Online- Ähnlichkeitsüberwachungsmodul.

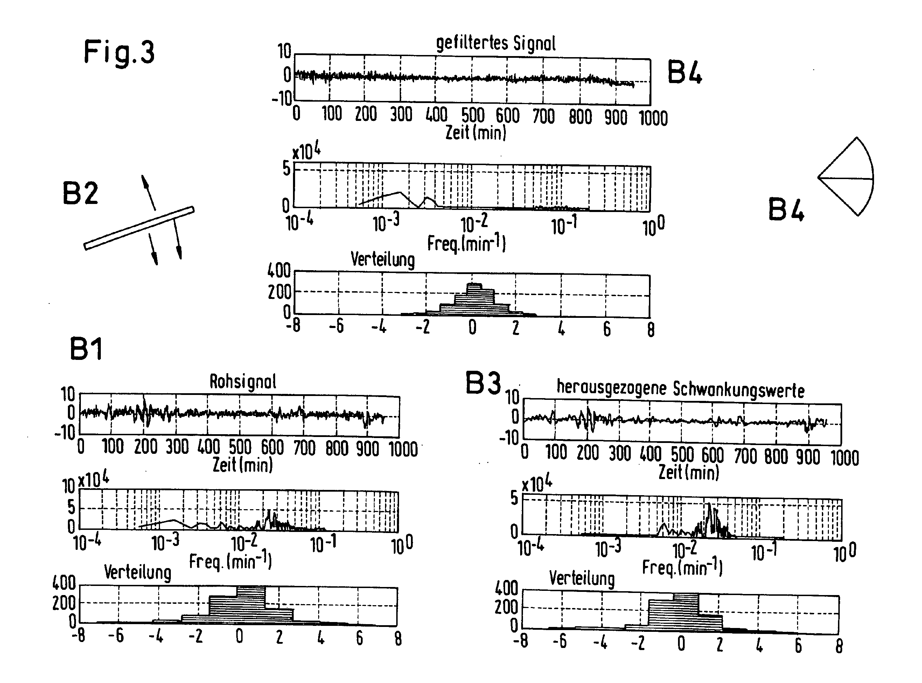

**Fig. 3** zeigt beispielhaft eine detaillierte Schwingungsanzeige, wobei die Prozess- und/oder Anlagesignale online für dominante Schwingungen mittels eines Analysemoduls so analysiert werden, dass die zuvor detektierten dominanten Schwingungen von entsprechenden Signal abgezogen und separat ausgewiesen werden. Die restlichen Signalkomponenten bewegen sich weniger, da sie weniger Variabilität aufweisen. Daher hilft die Darstellung, mehr regelmäßigere und stabile Muster zu zeigen. Die explizite Darstellung von Schwingungen hilft dem Anlagenfahrer auch eine langsame Schwingung zu erkennen.

In der **Fig. 3** sind Signalverläufe für ein ungefiltertes Rohsignal B1 und das Signal B3 dem Anteil der dominanten Schwingungen sowie eine Massendatenanzeige B2.

Das ungefilterte Rohsignal B1 besitzt eine starke Variabilität, was in der Massendatenanzeige B2 zu einer starken Unruhe führen würde. Das Signal B3 zeigt den Anteil der dominanten Schwingungen. Diese Schwingungen werden aus dem Signal entfernt und führen dann zu dem Signalverlauf B4. Das Signal B4 hat deutlich weniger Variabilität, das Massendatendisplayelement verhält sich deutlich ruhiger. Die Schwingung B3 wird im Massendatendisplay visualisiert, indem ein Kreisausschnitt gezeigt wird, der sich je stärker öffnet, je stärker die Schwingung ist. Anstelle eines sich stark hin- und her- bewegenden Strichs, wie als B2 gezeigt, erhält man einen Kreisausschnitt B4 der sich nur wenig bewegt. Dies erzeugt ein ruhigeres Bild, zum anderen werden die Schwingungen durch den Kreisausschnitt B4 explizit sichtbar gemacht.

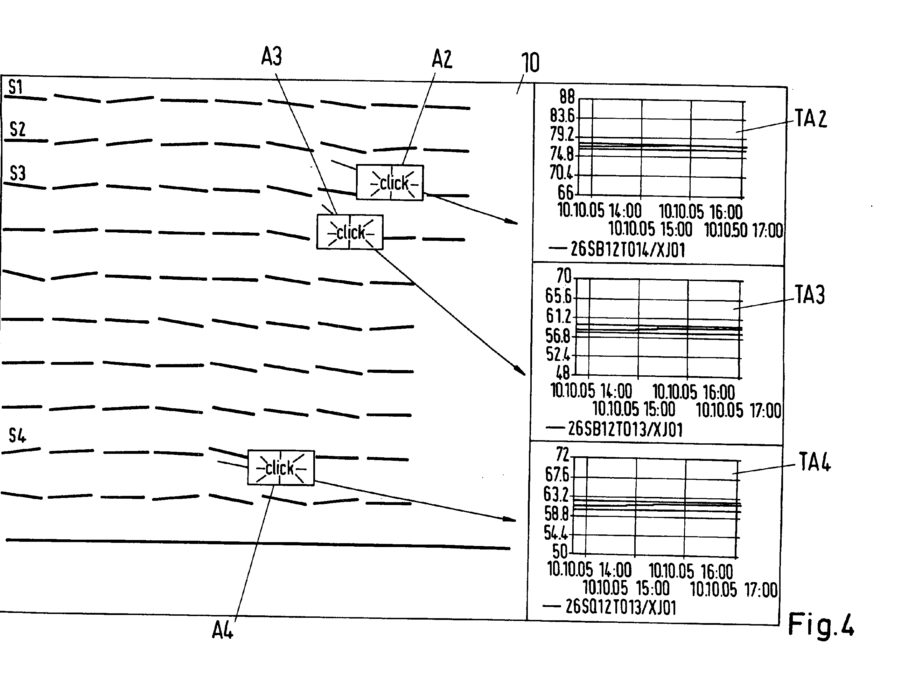

**Fig. 4** zeigt eine erfindungsgemäße Darstellung von Massedaten 10 auf einem Display eines Bildschirms der übergeordneten Steuerungsebene eines Automatisierungssystems, wobei die Signale S1, S2, S3, S4... normiert und abstrahiert sind, was gestattet große Mengen von Signalen zu zeigen und menschliche Fähigkeiten für den Abgleich von Mustern zu nutzen. Sobald eine Abweichung A2, A3, A4 innerhalb des dargestellten Signals S2, S3, S4 vom normalen im Sinne einer Fehlererkennung angezeigt wird, muss der Anlagenfahrer des Automatisierungssystems den Grund für diese Abweichung A2, A3, A4 analysieren. Für letzteres müssen sie die jeweiligen Prozess und/oder Anlagengrößen analysieren. Daher ist zwischen der abstrakten Darstellung von Massendaten 10 im Sinne einer Fehlererkennung und eine Standard-Trend-Anzeige als Fehlerdiagnose eine schnelle Verbindung erforderlich.

Erfindungsgemäß werden hierzu mehrere Trendanzeigen TA2, TA3, TA4 rund um die Massendaten-Darstellung 10 platziert. So ist es sehr einfach ein Element A2, A3, A4 aus der Massendaten-Darstellung 10 auszuwählen und die hierauf bezogene Prozessgröße in einer der Trendanzeigen TA2, TA3, TA4 darzustellen.

Nun sollen nochmals die Vorteile der Erfindung herausgestellt werden, die auf dem verschiedenen Darstellungsvarianten und deren Kombinationen beruhen.

Die beschriebene Technik erlaubt es, so systematisch Displays aufzubauen, die einen vollständigen Überblick über den Prozess bieten und gleichzeitig die Anzahl der angezeigten Prozess- und/oder Anlagedaten möglichst gering halten. Dabei werden Unruhe und Unregelmäßigkeiten in der Anzeige während des normalen Betriebs minimiert. Die Anlagenfahrer sind von lästigen Aufgaben wie die Beurteilung, ob ein Signal immer noch still ist oder noch ähnlich genug im Vergleich mit anderen Signalen entlastet. Schwingungen bei den Prozess- und/oder Anlagengrößen werden explizit sichtbar gemacht, ohne dass die sichtbaren Muster in der Gesamtdarstellung bei der Darstellung von Massendaten relevant beeinflusst werden. Die Verbindung zwischen einer Fehlererkennung, unterstützt von einer abstrakten und normierten Darstellung und der Fehlerdiagnose, unterstützt von Standard-Trend-Anzeigen, wird durch eine neue Kombination von abstrakt/normierter Anzeige der Massendaten und der Standard-Trend-Anzeigen einzelner Prozess- und/oder Anlagegrößen erreicht.

## Patentansprüche

1. Verfahren zur intelligenten Visualisierung bei der Überwachung von Prozess- und/oder Anlagedaten, welche bei technischen Verfahren beziehungsweise beim Betrieb technischer Anlagen benutzt werden, **dadurch gekennzeichnet, dass** die Erkenntnis ausgenutzt wird, dass sich viele Prozess- und/oder Anlagedaten, auch stille Signale (S1, S2, S3, S4) genannt, nach aus verschiedenen Gründen nicht ändern, und hierbei die Annahme gilt, dass Prozess- und/oder Anlagedaten sich in der Zukunft nicht ändern werden, wenn sie sich zumindest für einen gewissen Zeitraum in der Vergangenheit nicht geändert haben, wobei eine große Anzahl von diesen stillen Signalen (S1, S2, S3, S4) in einer einzigen Ansicht bzw. Darstellungsform (11) zusammengefasst werden, die stillen Signale (S1, S2, S3, S4) mittels Algorithmen überwacht werden und im Falle, dass ein Signal aktiv wird, dieses hervorgehoben, angezeigt und/oder gemeldet wird.

2. Verfahren nach Anspruch 1, **dadurch gekennzeichnet, dass** die Prozess- und/oder Anlagedaten Messwerte, Prozessgrößen und/oder Zustandsmeldungen einer technischen Anlage oder eines technischen Prozesses umfassen.

3. Verfahren nach einem der vorherigen Ansprüche, **dadurch gekennzeichnet, dass** die Prozess- und/oder Anlagedaten Massedaten, also einer Vielzahl von Prozess- und/oder Verfahrensdaten, umfassen.

4. Verfahren nach einem der vorherigen Ansprüche, **dadurch gekennzeichnet, dass** ein Signal aktiv wird, weil die geschätzte Varianz einer Prozess- und/oder Anlagengröße einen vorkonfigurierten Schwellwert überschreitet und/oder unterschreitet.

5. Verfahren nach einem der vorherigen Ansprüche, **dadurch gekennzeichnet, dass** eine Ähnlichkeits-Metrik definiert wird.

6. Verfahren nach Anspruch 4, **dadurch gekennzeichnet, dass** ein Algorithmus zur Auswertung der Ähnlichkeits-Metrik für alle Prozess- und/oder Anlagedaten angewendet wird.

7. Verfahren nach Anspruch 5 oder 6, **dadurch gekennzeichnet, dass** die Prozess- und/oder Anlagedaten, die als ausreichend ähnlich ermittelt worden sind, in einem einzigen Display bzw. in einer einzigen Ansicht angezeigt werden.

8. Verfahren nach einem der Ansprüche 5 bis 7, **dadurch gekennzeichnet, dass** die Ähnlichkeits-Metrik regelmäßig mittels eines Auswertemoduls (22) ausgewertet wird und Signale, die nicht mehr den Ähnlichkeits-Kriterien gehorchen, automatisch mittels eines Filtermoduls herausgefiltert und einer Summendarstellung bereitgestellt und/oder angezeigt werden.

9. Verfahren nach einem der vorherigen Ansprüche, **dadurch gekennzeichnet, dass** die Prozess- und/oder Anlagedaten online bezüglich dominanter Schwingungen mittels eines Analysemoduls analysiert werden.

10. Verfahren nach Anspruch 8, **dadurch gekennzeichnet, dass** detektierte dominante Schwingungen von dem Signal abgezogen und separat ausgewiesen werden.

11. Anzeigesystem zur intelligenten Visualisierung bei der Überwachung von Prozess- und/oder Anlagedaten, welche bei technischen Verfahren beziehungsweise beim Betrieb technischer Anlagen üblich sind, **dadurch gekennzeichnet, dass** eine einzigen Anzeige (11) zur Darstellung einer Vielzahl von stillen und/oder normierten Signalen vorgesehen ist.

12. Anzeigesystem nach Anspruch 11, **dadurch gekennzeichnet, dass** eine Überwachung der Signale mittels eines im System integrierten Überwachungsmoduls (21) detektierbar ist und zu einer Ansicht des Displays übertragbar und/oder dort darstellbar ist.

13. Anzeigesystem nach einem der Ansprüche 11 oder 12, **dadurch gekennzeichnet, dass** ein Schwellwertüberwachungsmodul vorgesehen ist, welches ein aktives Signal auswählt, wenn eine geschätzte Varianz der betreffenden Prozess- und/oder Anlagendaten einen vorkonfigurierten Schwellwert überschreitet.

14. Anzeigesystem nach einem der Ansprüche 11 bis 13, **dadurch gekennzeichnet, dass** die Erstellung einer Ähnlichkeits-Metrik und deren Auswertung für alle Prozess- und/oder Anlagengrößen mittels eines vorgegebenen Algorithmus ausführbar ist.

15. Anzeigesystem nach einem der Ansprüche 11 bis 14, **dadurch gekennzeichnet, dass** alle Signale, die nicht mehr den Ähnlichkeits-Kriterien gehorchen, automatisch in einer Summendarstellung zur Anzeige kommen.

16. Anzeigesystem nach einem der Ansprüche 11 bis 15, **dadurch gekennzeichnet, dass** alle Variablen, die als ausreichend ähnlich ermittelt worden sind, in einem einzigen Display zur Anzeige kommen.

17. Verwendung des Systems und Verfahrens nach einem der vorherigen Ansprüche in der technischen Planung, insbesondere der Verfahrenstechnik, der Anlagentechnik, dem Anlagenbau, der Automatisierungstechnik, der Elektrotechnik oder der Verkabelung.
